(19) Europäisches Patentamt
European Patent Office
Office européen des brevets

(11) **EP 2 223 405 B1**

(12) # EUROPEAN PATENT SPECIFICATION

(45) Date of publication and mention
of the grant of the patent:
**17.10.2012 Bulletin 2012/42**

(21) Application number: **07819538.5**

(22) Date of filing: **02.11.2007**

(51) Int Cl.:
***H02J 3/01*** *(2006.01)*        ***H03H 17/02*** *(2006.01)*

(86) International application number:
**PCT/EP2007/009512**

(87) International publication number:
**WO 2009/056158 (07.05.2009 Gazette 2009/19)**

(54) **METHOD AND DEVICE FOR FILTERING A FILTER OUTPUT CURRENT AND / OR VOLTAGE OF AN INVERTER OUTPUT**

VERFAHREN UND EINRICHTUNG ZUM FILTERN EINES FILTERAUSGANGSSTROMS UND/ODER EINER FILTERAUSGANGSSPANNUNG EINES UMRICHTERAUSGANGS

PROCÉDÉ ET DISPOSITIF POUR FILTRER UN COURANT ET/OU UNE TENSION DE SORTIE DE FILTRE D'UNE SORTIE D'INVERSEUR

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**01.09.2010 Bulletin 2010/35**

(73) Proprietor: **Voltwerk Electronics GmbH**
**20537 Hamburg (DE)**

(72) Inventor: **KOCH, Karl**
**63776 Mömbris (DE)**

(74) Representative: **Eisenführ, Speiser & Partner**
**Johannes-Brahms-Platz 1**
**20355 Hamburg (DE)**

(56) References cited:
**JP-A- 4 364 378**

- **BEIDES H M ET AL: "DYNAMIC STATE ESTIMATION OF POWER SYSTEM HARMONICS USING KALMAN FILTER METHODOLOGY" IEEE TRANSACTIONS ON POWER DELIVERY, IEEE SERVICE CENTER, NEW YORK, NY, US, vol. 6, no. 4, 1 October 1991 (1991-10-01), pages 1663-1670, XP000271663 ISSN: 0885-8977**
- **BOJRUP M ET AL: "A MULTIPLE ROTATING INTEGRATOR CONTROLLER FOR ACTIVE FILTERS" 8TH EUROPEAN CONFERENCE ON POWER ELECTRONICS AND APPLICATIONS. LAUSANNE, CH, SEPT. 7 - 9, 1999; [EPE . EUROPEAN CONFERENCE ON POWER ELECTRONICS AND APPLICATIONS], BRUSSLS : EPE ASSOCIATION, BE, vol. CONF. 8, 7 September 1999 (1999-09-07), pages 1-09, XP000878439 ISBN: 978-90-75815-04-7**

**Description**

The present application is directed to a method for estimating or filtering the filter output current or voltage of an output filter of an inverter connected to the grid as set forth in the classifying portion of claim 1. The invention further concerns a method for detecting distortions of a filter output current or voltage of an output filter of an inverter connected to the grid according to the classifying portion of claim 9, and a method for minimizing the total harmonic distortion of an output current or voltage at an output filter of an inverter connected to the grid as set forth in the classifying portion of claim 13. The present invention concerns even further an inverter involving such methods and a solar system comprising such an inverter.

Grid inverters are widely used, e. g. to connect solar power generators to a public grid. Most commercially available devices are optimized to supply a sinusoidal AC-current at grid frequency independent of the grid voltage distortion. However it is desired to add damping harmonics to the AC current which attenuates the grid distortion. Grid connected inverters are equipped with L-C-L filters to minimize the total harmonic distortion at the inverter output. The filters are designed according to the inverter typology (i. e. supporting single-phase or three-phase current feed to mains). The transfer function of a typical filter design shows a significant resonance peak which has to be attenuated to satisfy national power supply standards.

Know commercial solutions are based on a filter model with known parameters of the L-C-L filter to be modelled. Since device tolerances and time varying parameter drift during the operation cannot be avoided these methods show substantial performance degradation with increasing parameter mismatch. In other words, according to the prior art solutions, a compensation is designed only with respect to one exactly given model. However, at least the quality of this compensation will decrease, if the model does not exactly comply with the given system, in particular with the given L-C-L filter. Such differences can occur in the first place due to not exactly modelling the corresponding system. In the second place, the actual parameters of the system will change at least slightly, e. g. due to temperature effects of the like.

As a result, the compensation does not completely fit to the actual system. In particular, the compensation does not correspond to the frequency of the resonance peak of the filter. Such a mismatch of the modelled frequency and the actual frequency of the resonance peak may result In a poor compensation of said resonance peak. Depending on the compensation technique and the mismatch, the compensation might in some cases even result in an enhancement of the resonance peak. Even further, it is to be noted that compensation problems might not be recognized, because the output of the output filter is connected to the grid, which usually does not comprise a clear sinusoidal signal. I, e. even a measurement of the output voltage might show distortions, but the measurement will not give a conclusion as whether the distortions correspond to an insufficient compensation or to problems inherent to the grid.

The document of BEIDES H M ET AL: "DYNAMIC STATE ESTIMATION OF POWER SYSTEM HARMONICS USING KALMAN FILTER METHODOLOGY", is directed to a state estimation of power system harmonics in the process of estimating the bus voltage magnitude and phase angles of the fundamental and higher harmonics from redundant and noisy measurements. This document proposes to use a Kalman filter to obtain the optimal estimate of the power eye-tern harmonic content. The Japanese publication JP 4 364 378 A is directed to an output from a solar electric power generator, being converted by an inverter and higher harmonics being filtered by a filter and the power being linked to a commercial power system after closing a switch. An output current of the inverter and a voltage of a power distribution system are disclosed to be Inputted to an AC detector.

Accordingly, one object of the present invention is to improve the output signal at the L-C-L filter output and in particular to improve the attenuation. The invention further aims to provide a solution which is less dependent on the parameters of the filter components or the grid impendance than known by the prior art. In particular, one aim is to provide a solution, which is independent on at least one or all of the parameters mentioned above.

Accordingly, the invention provides a method for estimating or filtering an alternating voltage or current signal comprising the steps:

defining a general signal structure to represent the estimated signal by means of a sinusoidal function having a fundamental wave and at least one harmonics of higher order, whereby the sinusoidal function is defined by the frequency, amplitude and phase of the fundamental wave and the amplitude and phase of each harmonic,
estimating the amplitude and phase of the fundamental wave and/or each harmonic by means of a filter, an adaptive filter and/or an observer, in particular a Kalman filter,
whereby the estimated signal is compared with the corresponding measured signal.

According to one embodiment of the invention the alternating voltage or current signal is an output current or voltage of an output filter of an inverter or other controlled power source connected to the grid as set forth in claim 2. Such a controlled power source might be an ac-power supply or an ac-current source. Accordingly, a general signal structure is defined to represent the estimated filter output current or voltage. In other words, a basic structure or model of the generally expected signal at the filter output is provided. Its general signal structure comprises a fundamental wave of a sinusoidal function as the filter output is connected to the grid and the grid comprises a sinusoidal function of the voltage. However the grid voltage and thus the filter output voltage comprises distortions. These distortions may depend on a plurality of reasons, in particular because of unsymmetric loads at the grid. The general signal structure i. e. the model of the estimated filter output signal takes these distortions into account by means of comprising at least one further harmonics of higher order. For example, the first ten harmonics are taken into account. Usually, distortions in the grid voltage mainly influence the first ten harmonics and further harmonics can often be neglected.

To adapt this general signal structure to the estimated filter output signal amplitude and phase of the fundamental wave and the harmonics have to be set and have to be adapted. This is done by means of a filter, an adaptive filter and/or an observer, in particular a Kalman filter. The resulting modelled signal is compared to the measured signal and the difference of both signals acts by way of a correction or adaption function to adapt or tune said amplitudes and phases.

It is to be noted, that the frequency of the resonance peak is expected to be larger than the frequency of the tenth harmonic and it will properly not be a multiple of the grid frequency. As a result, the modelled signal will not or only very poorly contain or represent the resonance peak. Therefore, the resonance peak will quite clearly remain in the difference of the modelled signal and the measured signal.

The method according to claim 1 can in general use any kind of observer or filter, in particular an adaptive filter for estimating amplitudes and the phases. However, since the measured signal is expected to comprise noise, it is advantageously to use a Kalman filter.

According to one aspect of the invention, a sinusoidal function having a fundamental wave and at least one harmonics of higher order corresponding to the structure and the frequency of the estimated filter output current is used as an input signal of the observer. E. g. with respect to the European grid having a frequency of 50 Hz the fundamental wave of the input signal will also have a frequency of 50 Hz. If e. g. ten harmonics (including the fundamental wave) will be chosen to model the general signal structure, the fundamental wave will additionally provide harmonics of the frequency of 100 Hz to 500 Hz. The phases and the amplitudes of the input signal of the observer may just be set to any value, e. g. all phases are set to 0 and all amplitudes are set to 1.

According to a further aspect of the invention the input signal of the observer is defined by the frequency of its fundamental wave and the phase and amplitude of each of its fundamental wave and its harmonics and whereby at least some of the values are predefined values. Accordingly, the input signal is not in fact a measured signal inputted into the observer, but an emulated one defined by its parameters and these parameters are - at least some of them - inputted into the observer. As stated above, amplitude and phase of the fundamental and / or the harmonics of the input signal of the observer may take any value and thus can be predefined beforehand. In particular, the frequency of the fundamental wave which corresponds to the frequency of the grid (e. g. 50 Hz) is given as an input signal into the observer. This frequency will often be a measured value, measured from the voltage signal in the grid, for example by measuring positive zero crossing of the grid signal and calculating the corresponding frequency. The amplitudes and the phases may just take any value and thus their values can be predefined and it is not necessary to calculate or recalculate these values all the time.

Even further, and according to one aspect of the invention it may even not be necessary to feed these values into the observer as an input signal, but to calculate these values within the observer or to get these values out of a memory within the observer. I. e. according to one example it is only needed to input the approximately 50 Hz (in case of a European grid) or e.g. 60 Hz (for the US) into the observer as an input signal. Within the observer the values for the amplitudes and phases for the fundamental and the harmonics of the input signal are set by the observer.

If the values for amplitudes and phases are provided or calculated inside the observer even further calculations within the observer can take these values of the amplitudes and phases of the input signal into account. Accordingly, any calculations within the observer can be adapted to the fact, that some values of the input signal where known beforehand. At least some computations can than be performed on the predetermined values in an offline manner with respect to the observer operation and / or respective results can be saved as values for use in the observer computation. E. g. if these values of the amplitude and phase are constant values any multiplication with such input value with a factor can be substituted with a new factor. Even further, any amplitudes comprising ones are ineffective with respect to any multiplication and the value of zero for any phases of the input signal are ineffective for any addition or subtraction, to give only some examples. Accordingly, the value for the amplitudes and the phases within the observer will result in a reduction of the complexity of the observer.

According to a further aspect of the invention the amplitude and phase of a fundamental wave and of harmonics of the estimated filter output signal and / or the input signal are represented by a complex value. This way, known procedures for calculating values, as often provided in processors and the like such as a digital signal processor (DSP) can be used. Each harmonics can be represented by one single complex value.

According to one aspect of the present invention the frequency of a fundamental wave of a measured filter output signal and / or the frequency of the grid is inputted into the observer as frequency of the fundamental wave of the input signal. The measured frequency might be the only input signal. It is to be noted, that the frequency of the grid is a quite important information of the signal to be estimated. However, according to an other possibility it might as well be sufficient to observe and adapt the frequency of the fundamental wave i. e. the frequency of the grid.

With respect to one aspect of the invention, the alternating voltage signal is the voltage of the grid, in particular of the public grid or of a private grid. I. e. it is not necessary to measure the signal at an output of an inverter or other power source, but anywhere in the grid. However the grid voltage may of course also be measured at the output of such a device. As a result, the grid voltage is estimated or filtered in particular to receive characteristic information of the voltage, in particular of distortions characterised by the harmonics of the estimated signal.

To improve the quality of the voltage in the grid, the estimated or filtered voltage signal of the grid provides a good basis to modify the grid voltage, in particular to reduce distortions. Accordingly it is proposed to eliminate, compensate and/or modify at least one component of the grid voltage.

According to one aspect of the invention, an inverter or other power source modulates a voltage and/or current signal for feeding into the grid in order to modify the grid voltage according to the estimated grid voltage. This way, the grid voltage can directly be influenced. In particular, an arbitrary signal shape can be provided. As one example, the $2^{nd}$ and further harmonics can be reduced in order to more precisely get to a sinusoidal shape of the voltage in the grid. The harmonics may also be shifted with respect to their phase, to get a more symmetrical shape of the grid voltage. The person skilled In the art generally knows methods and tools to modify a generally sinusoidal voltage signal comprising further harmonics. However, to perform such modifications, good knowledge of the shape of the voltage signal is necessary. The invention gives a solution, or at least an approach to this problem and provides information of the grid voltage to allow for a good modification of the grid voltage.

According to the invention it is further provided a method for detecting distortions of a filter output current or voltage of an output filter of an inverter or other power source connected to the grid, comprising the steps: estimating a filter output current or voltage of the filter by means of a filter, an adaptive filter or an observer, in particular a Kalman filter, and estimating the distortions by comparing the estimated signal with a measured reference signal of the filter. Accordingly, a filter output signal of the output filter is estimated according to a first step. The estimated signal of the filter output signal depends on the output filter as well as on the grid. The estimated filter output signal will, according to the design of the observer basically provide an estimated signal representing a signal comprising grid induced distortions. However, the estimate of the observer will not or only in a small extend contain the resonance peak or any resonance peaks of the output filter. Accordingly, the difference of the measured reference signal of the filter and the estimated filter output signal will basically indicate filter related distortions, in particular a resonance peak.

According to one aspect of the invention the estimation of the filter output signal used to detect filter related distortions is performed as described in the paragraphs and pages above. In particular, a structure of the filter output signal is provided, comprising a fundamental wave having the frequency of the grid and at least one further harmonics. The choice of the structure for the estimated filter output signal at least partly specifies that part of the output signal, that can be estimated by means of the observer. If the structure only comprises the fundamental wave of the grid and harmonics of the grid i. e. only the base frequency and the multiple thereof, any signal behaviour of frequencies in between and / or above the considered frequencies cannot be represented by the chosen restricted structure of the estimated signal.

According to a further embodiment the filter related distortions are detected at a L-C-L low pass filter having two inductances and a capacitor connected in a T-structure being used as the output filter and whereby the distortion of the output signal of the filter is detected by estimating a filter output signal at the output filter and comparing it with a measured signal of the filter representing the output signal. Accordingly, the method for detecting filter related distortions is in particular advantageous in relation with a L-C-L low pass filter. It is to be noted, that the inductances and the capacitor are not necessarily connected on one circuit board. E.g. one of the inductances may just be a connection wire or a consumer or a load in the grid.

According to a further aspect of the invention, when using an L-C-L low pass filter having two inductances and a capacitor connected in a T-structure the voltage at the capacitor is used as the observer reference and it is used to calculate the observer error. Such a filter having a T-structure will receive - during an operation - an input current $I_{L0}$ from the inverter flowing into a first inductance. The filter output current $I_{L1}$ will flow through a second inductance to the output of the filter. The difference of these two currents $I_{L0}$ and $I_{L1}$ is a current $I_c$ flowing into the capacitor of this filter. It is to be expected, that the current $I_{L0}$ provided by the inverter will not comprise a resonance peak, whereas the filter output current $I_{L1}$ will comprise this resonance peak. Accordingly, the current $I_c$ as being the difference of the currents $I_{L0}$ and $I_{L1}$ will comprise this resonance peak but at least not the fundamental wave of both currents $I_{L0}$ and $I_{L1}$ because these two currents will basically have the same fundamental wave

The difference of the filter input and filter output currents $I_{L0}$ and $I_{L1}$ can be measured and this difference is, according to Kirchhoff, the current of the capacitor $I_c$. However the voltage of the capacitor which is basically the integrated current can also be measured and will basically be a phase shifted signal with respect to the current $I_c$.

According to the invention it is further proposed a method for minimizing the total harmonic distortion of an output current or voltage of an output filter of an inverter connected to the grid, comprising the steps: generating an inverter output current inputted into the output filter by means of the inverter, detecting a distortion signal of the filter output current by means of an observer, in particular a Kalman filter and adapting the generating of the inverter output current to compensate for the detected distortion. Accordingly, for feeding electrical current into the grid an inverter generates an inverter output current which is inputted to an output filter. Distortions will appear on the filter output signal i. e. the current leaving the output filter and / or the output voltage of the filter. Since the voltage of the connected grid does usually not provide a signal having an ideal sine-shape it is very difficult, to distinguish filter related distortions from the shape of the voltage provided by the grid. To overcome this problem a filter related distortion signal is detected by means of an observer, in particular a Kalman filter which is advantageously used, if the relevant signal or signals comprise noise.

An inverter, comprising an output filter connected to the grid provides at the output of the output filter an output current to be fed into the grid. In theory, the voltage of the grid as well as the output current have a sinusoidal shape. In reality however, the voltage of the grid does usually not provide a sinusoidal shape, but is somehow distorted compared to a clear sinusoidal shape. Accordingly, this influences the output current which is to be fed into the grid. The output current will accordingly differ from an idealized sinusoidal current. In addition, the output filter will result in a signal having a resonance peak at a certain frequency being on top of the not ideal sinusoidal signal. This makes it extremely difficult to detect the filter related distortion. And thus, it is difficult to amend the output signal of the inverter, such, that only the distortion comprising said resonance frequency is deleted or at least attenuated. In other words, the basic aim is not only to compensate a single distortion signal on top of a sinusoidal function, but to deal with a distortion signal, which is on top of an already distorted and basically - except for the frequency - unknown signal.

If the distortion is detected, the inverter can be adapted to generate a current, which will compensate for the detected distortions in current and/or voltage. Because of using an observer to detect the distortions, any variations resulting in a change in the distortion of the output current will be recognized and considered by the inverter. Accordingly, this method for minimizing the total harmonic distortion is tolerant to variations of the output filter and thus it is tolerant to variations of the characteristics of the output filter.

As explained above, to delete or attenuate an output filter related distortion signal having a resonance frequency the invention proposes an approach comprising three general steps:

In the first step the filter output signal of the output filter without the filter related distortion signal is estimated. In the second step the filter related distortion signal, in particular a resonance peak, is determined based on the estimated filter output signal. Finally, in the third step, based on the estimated filter output signal and the detected distortion signal the inverter control is changed such, that the filter related distortion signal is at least attenuated.

According to a further aspect of the invention the method for minimizing distortions is used on an inverter having a L-C-L low pass filter having a T-structure with at least two inductances and one capacitor. In this case the distortion signal is detected by measuring the voltage at the capacitor and a set value for the current generated by the inverter is adapted according to the measured voltage at the capacitor. According to this configuration the inverter will feed a current into the output filter resulting in a filter output current comprising only some or optimally, this filter output current will comprise no distortions. Consequently, according to Kirchhoffs current law the difference between the input and the output current is the capacitor current $I_c$ into the capacitor. This capacitor current $I_c$ therefore represents the distortion. To attenuate the distortions one possibility is to add on the differentiated distortion signal at the input of the filter i. e. to add the differentiated distortion signal onto the input current, to get an attenuation of the corresponding distortion at the output signal i. e. since the distortion signal, in particular the distortion signal received by taking the difference of the output current and the estimated signal will provide noise and it is quite difficult to differentiate a signal comprising noise.

However, the distortion signal is expected to mainly comprise a sinusoidal signal having a frequency according to the frequency of the resonance peak of the filter related distortion. As a result, and according to one aspect of the current invention it is recognized, that differentiating a sinusoidal signal is basically the same as integrating a sinusoidal signal, except for amplitude and phase or algebraic sign respectively. Accordingly, for attenuating the distortion at the current output can easily be achieved by adding the integrated distortion signal with adapted amplitude and algebraic sign to the input current. The input current is changed by amending the set signal for the input current accordingly. Controlling the inverter according to the given or amended set signal is performed as generally known in the state of the art

According to the present invention there was found one simple way of receiving an integrated signal of the distortion signal, by simply measuring the voltage at the capacitor of an L-C-L low pass filter having a T-structure.

According to a further embodiment of the present invention the suggested method further comprises the step of amending the inverter output current to compensate for reactive power. It is in general difficult to receive detailed and useful information about the electrical current and voltage in the grid in particular because of noise on the voltage signal. According to one aspect of the present invention estimating the current is proposed. Such an estimation of the current cannot only be used for attenuating a filter related distortion, but to influence the current in general. Accordingly, it is proposed to amend the inverter output current such, that reactive power can be at least partly compensated. It is thus proposed, to generate an output current of an arbitrary shape, to result in an improved shape of the current in the grid.

To compensate for reactive power is one main subject, but the knowledge of the shape of the current and / or the voltage received by estimating the current or voltage as explained above can also be used for aiming any other improvements of the shape of the current in the grid. I. e. if the current comprises any distortions such as unwanted peak values the output current can be adapted accordingly. Such a generating of an arbitrary output current shape may also be fulfilled without performing any step to attenuate a filter related distortion.

According to one aspect of the present invention an inverter for feeding current into the grid is proposed, comprising a low pass filter for filtering the current in a processing unit adapted to perform at least one of the described methods. Accordingly, an inverter can be improved with respect to its output current by implementing an inventive method in the processing unit. According to one aspect the processing unit is realized as a digital signal processor (DSP). Such a digital signal processor can be connected to the inverter or form part of the inverter and can further be programmed in a desired way. This is only one way of adapting an inverter to improve the output current by means of the described inventive method.

According to one embodiment of the invention, an inverter is proposed having an output filter having a resonance frequency above the tenth harmonic frequency of the grid frequency. E. g. being above 500 Hz (for Europe) and above 600 Hz (for the US). E. g. the resonance frequency can be in the range of 1-2 kHz. This provides for a good filter to smooth the current generated by means of a pulse-width-modulation or the like. And such resonance frequency provides for a resonance peak being different to net related distortions.

It is preferred to have a solar system that comprises a solar generator and at least one of the inverters described above. Accordingly, solar energy received from the solar generator can be fed into the grid, whereby the current fed into the grid is improved with respect to attenuating distortions. Additionally, connecting such a solar system to the grid might even improve the current and/or the voltage in the grid.

Embodiments of the present invention will now be described making reference to the accompanying figures, wherein

Fig. 1 shows the principle of an adaptive grid synthesis,

Fig. 2 shows the principle of a known adaptive filter system identification,

Fig. 3 shows the principle of an adaptive filter structure according to one aspect of the present invention,

Fig. 4 schematically shows a typical L-C-L output filter in a T-structure being connected between a converter and a grid,

Fig. 5 shows the structure of a simulation model for simulating a 3-point half bridge connected to an L-C-L low pass filter in T-structure for testing the efficiency of different embodiments of the invention and

Fig. 6a-c show simulation results with and without attenuation.

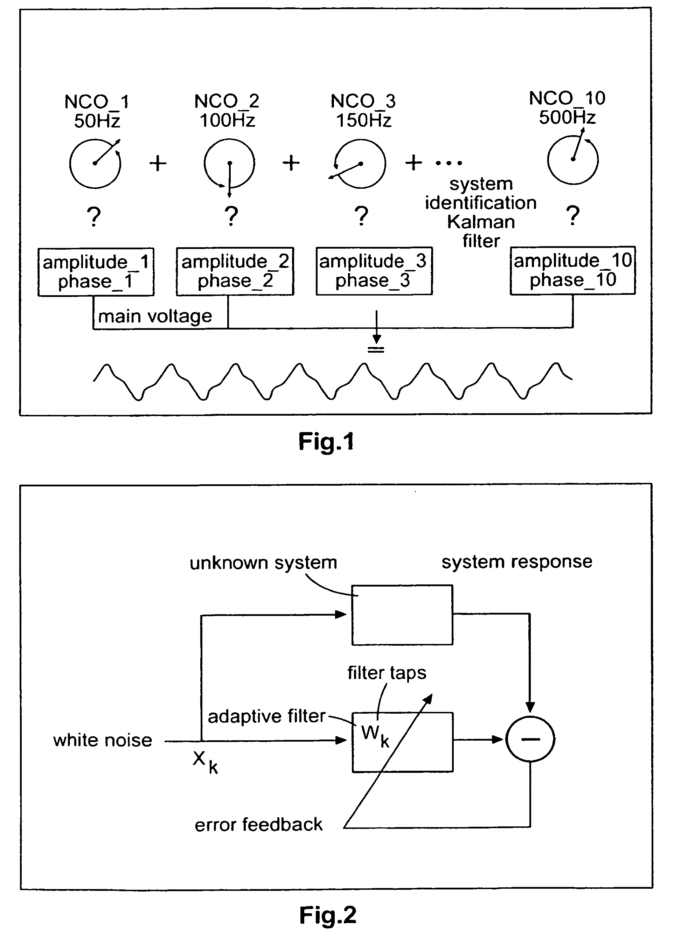

With respect to grid inverters connected to a public grid it is desired to add damping harmonics to the AC-current to attenuate the grid distortion. This needs detailed knowledge about amplitude and phase of each harmonic oscillation, such that the damping harmonics can be tailored. According to the invention, a new method is suggested to estimate the grid harmonics by adaptive filtering. The adaptive filter determines how a set of numerically controlled oscillators (NCO) twiddling at the harmonic frequencies such as 50 Hz, 100 Hz, 150 Hz and so on must be assembled to synthesize the grid voltage. Figure 1 illustrates this principle of the main voltage being synthesized by means of assembling such numerically controlled oscillators. Each such oscillator NCO_1 to NCO_10 comprises an amplitude and a phase. Additionally, the frequency is known, whereby it is known for the base numerically controlled oscillator NCO_1, which is 50 Hz in the given example. The frequency of the remaining numerically controlled oscillators NCO_2 to NCO_10 are just a multiple of the base frequency. The resulting main voltage is a periodical signal, but usually not a clear sinusoidal signal, as illustrated in figure 1. A Kalman filter is used for system identification to estimate the amplitude and phase of each numerically controlled oscillator NCO_1 to NCO_10.

The Kalman filter is known to be an excellent tracker in system for identification tasks that need to follow time varying parameters. But this is achieved at the cost of high computational expense. Adaptive grid synthesis as described here can avoid that draw back as will be described later on.

Figure 2 illustrates in general the known principle of system identification using an adaptive filter. It is depicted the signal flow of a typical system identification DSP algorithm. Accordingly, an unknown system and an adaptive filter are connected to a source of white noise. The system output and the filter output are compared by calculating an error value. The error value is used as a feedback signal to tune the filter taps $W_k$. As the adaptive process attempts to reduce the power of the error signal, the filter coefficients will be adjusted in a way that the impulse response of the unknown system is estimated. In case a convergent behaviour the adaptive filter clones the response of the unknown system. The input signal is chosen white, because in that case the output of the adaptive filter contributes to the error value on all relevant frequencies, reducing the convergence time to a minimum.

However, this generally known principle of an adaptive filter system identification as depicted in figure 2 can hardly be adapted to the current problem. The reason is, that in particular there is no access to the input signal of the unknown system, that produces the current and the voltage of the grid. In fact, there even is no input signal to the grid but a plurality of influences forming the grid. In particular, there is no possibility to input any test signal such as a white noise. It is also difficult or impossible to synthesize such unknown system.

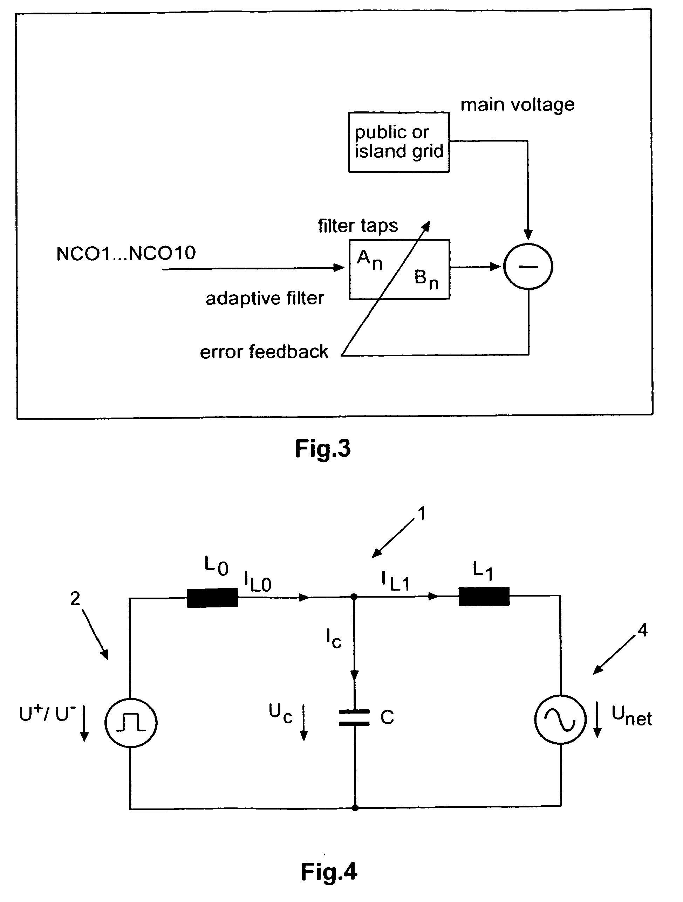

Fig. 3 shows the principle of adaptive filter grid synthesis according to at least one aspect of the invention. As illustrated the adaptive grid synthesis does not provide an input signal to the public or island grid (also known as private grid). E.g. there is no common input signal to the grid and the model comprising the filter tabs $A_n$ and $B_n$. According to one embodiment, numerical controlled oscillators NCO_1 to NCO_10 are inputted into the model and it is assumed, that the grid will provide a somehow similar signal. The output signal of the model is compared to (subtracted from) the main voltage or grid voltage respectively. The result, designated as error feedback, is inputted into the model to modify the filter taps, in order to minimize the error of the grid voltage and the model output. As a result, the filter taps, i.e. the amplitude and phase of each numerically controlled oscillator are adapted to minimize the resulting error.

As one example, figure 3 shows 10 NCO (50Hz, 100Hz, ...500Hz), to represent a sinusoidal signal comprising 10 harmonics. This number was found to be sufficient, since higher harmonics usually have only small amplitudes and few influence on the signal. However, more or less NCO might be chosen, depending on the grid, the aimed accuracy, the convergence time and other needs and circumstances.

According to the invention the synthesis is directed to the grid signal. According to the invention the periodical grid signal $g(t)$ is written in form of series expansion.

$$g(t) = \sum_n A_n \cdot \cos(n\omega t) + \sum_n B_n \cdot \sin(n\omega t) \qquad\qquad [1]$$

The requirement is to identify the series coefficients $A_n$ and $B_n$. if the unity oscillators $\cos(n\omega t)$ and $\sin(n\omega t)$ and the observed grid $g(t)$ are known.

The equation above can also be given in vector notation as follows:

$$g(t) = \begin{bmatrix} A_1 & B_1 & A_2 & B_2 & \ldots & \ldots \end{bmatrix} \begin{bmatrix} \cos(\omega t) \\ \sin(\omega t) \\ \cos(2\omega t) \\ \sin(2\omega t) \\ \vdots \\ \vdots \end{bmatrix} \qquad\qquad [2]$$

Using the substitutes

$$\langle w| = \begin{bmatrix} A_1 & B_1 & A_2 & B_2 & \ldots & \ldots \end{bmatrix} \qquad\qquad |x\rangle = \begin{bmatrix} \cos(\omega t) \\ \sin(\omega t) \\ \cos(2\omega t) \\ \sin(2\omega t) \\ \vdots \\ \vdots \end{bmatrix}$$

yields

$$g(t) = \langle w \,|\, x \rangle \qquad\qquad [3]$$

With respect to the adaptive filtering process shown in fig. 2 the series coefficients $\langle w\,|$ represent the filter taps $w_k$ and the filter input samples $x_k$ are given by the set of unity oscillators $|\,x\rangle$. The dimension of $\langle w\,|$ and $|\,x\rangle$ determine the highest harmonic order to be identified. I. e. the dimension is two times the harmonic order and in fact each order is represented by a complex amplitude. White noise system excitation can be replaced by harmonic oscillations yet retaining the alertness of the tracking process. This is due to $|\,x\rangle$ coordinates fulfilling the orthogonality criterion (which also applies to white noise). This can be explained by means of the following equations:

$$\int_{-\infty}^{+\infty} \sin(k\omega t)\cdot \sin(l\omega t)\,dt = \delta_{kl}$$

$$\int_{-\infty}^{+\infty} \cos(k\omega t)\cdot \cos(l\omega t)\,dt = \delta_{kl}$$

$$\int_{-\infty}^{+\infty} \sin(k\omega t)\cdot \cos(l\omega t)\,dt = 0$$

A corresponding equation for white noise expressing the orthogonality criterion is:

$$\int_{-\infty}^{+\infty} x_k(t)\cdot x_l(t)\,dt = \delta_{kl}$$

As a general information please note that:

- scalar values are printed in standard small font

- vectors are indicated using a bra $|\square\rangle$, its transposed by a ket $\langle\square|$

- matrices are noted in bold capital letters

According to one embodiment of the present invention an algorithm has been programmed and applied, which is a modification of the Kalman filter. The Kalman filter as generally known without modification is given by the following equations:

### 1. A priori adaptive filter output

$$\hat{g}_n = \langle \hat{w}_n \,|\, x_n \rangle$$

**2. A priori estimation error**

$$e_n = g_n - \hat{g}_n$$

**3. Filtered data vector**

$$|f_n\rangle = \mathbf{O}_{n-1} \cdot |x_n\rangle$$

**4. Kalman gain vector**

$$|k_n\rangle = \frac{1}{\alpha + \langle x_n | f_n \rangle} \cdot |f_n\rangle \qquad \text{[4A]}$$

**5. Optimal filter coefficients update**

$$|\hat{w}_n\rangle = |\hat{w}_{n-1}\rangle + e_n \cdot |k_n\rangle$$

**6. Auto-covariance matrix update**

$$\mathbf{O}_n = \mathbf{O}_{n-1} - |k_n\rangle\langle f_n| + \beta \cdot \mathbf{I} \qquad \text{[4B]}$$

Accordingly, the filter coefficients and thus the filter output are calculated and thus tracked by means of a loop. The filter output $\hat{g}$ is calculated by multiplying the current filter coefficients w and the current input samples x. An a priori estimation error e is calculated by subtracting $\hat{g}$ from g. For the next step the filtered data vector | f > and the Kalman gain vector | k > have to be calculated and the optimal filter coefficient update I w > and the auto-covariance matrix O have to be updated as can be seen in the given formulas. The Kalman gain vector I k > is also dependent on $a$, which basically represents the sensitivity. The update of the auto-covariance matrix $\Omega$ is also dependent on the constant value $\beta$, which represents expected variations.

An identification experiment gave evidence, that the estimation error of the grid harmonics is close to white noise which is due to the orthogonal harmonics. I. e. the auto-covariance is approximately a scaled identity. Accordingly, with respect to the present invention it was assumed to be constant and the update equation 6 was omitted and according to one embodiment of the invention replaced by the following:

$$\mathbf{O}_n = \beta \cdot \mathbf{I} \qquad \text{[5]}$$

It is to be noted that this constant factor in the equation above might be different but is typically equal to the constant factor as given in the known auto-covariance matrix update equation as given above in item 6 or equation 6 respectively. According to this modified equation for calculating the auto-covariance matrix this constant value corresponds to the expected variations.

Having a simplified calculation of the auto-covariance matrix **O** the calculation of the filtered data vector $| f_n >$ can be simplified as given above:

$$|f_n\rangle = \beta \cdot |x_n\rangle \qquad \text{[6]}$$

Additionally, the Kalman gain vector calculation is also simplified:

$$|k_n\rangle = \frac{\beta}{\alpha + \beta \cdot \langle x_n | x_n \rangle} \cdot |x_n\rangle$$

According to one aspect of the invention, the input vector $|x\rangle$ contains only *cos*- and *sin*-functions. As a result, $\langle x | x \rangle$ represents a series of squares of cos and *sin*. As $COS^2 + sin^2$ equals 1, the product of the input samples can be calculated:

$$\langle x | x \rangle = n$$

whereby n is the harmonic order i. e. the number of numerically controlled oscillators. Thus the Kalman gain simplifies to:

$$|k_n\rangle = \frac{\beta}{\alpha + n \cdot \beta} \cdot |x_n\rangle \equiv \mu |x_n\rangle \qquad [7]$$

As a result, the Kalman gain can be computed without the knowledge of the filtered data vector and the former equation 3 can be cancelled. The explained considerations according to one embodiment of the present invention lead to a simplified computation of the Kalman filter update:

**1. A priori adaptive filter output**

$$\hat{g}_n = \langle \hat{w}_n | x_n \rangle$$

**2. A priori estimation error**

$$e_n = g_n - \hat{g}_n$$

**3. Kalman gain vector**

$$|k_n\rangle = \mu |x_n\rangle$$

**5. Optimal filter coefficients update**

$$|\hat{w}_n\rangle = |\hat{w}_{n-1}\rangle + e_n \cdot |k_n\rangle \qquad [8]$$

For performing this simplified computation of the Kalman filter update the input vector $|x\rangle$, and the measured output signal g of the system must be known as input values. However, the numerically controlled oscillators are known beforehand and do not need to be measured but can be calculated inside the filter. Only the actual frequency of the grid is inputted according to one embodiment. One possibility to incorporate the frequency is by measuring the crossing of zero of the grid voltage or other corresponding voltage e. g. on a positive slope. Accordingly, a rising signal, rising from zero to $2\pi$ e. g. in a form of a sawtooth manner. This signal can be inputted in every cos- and *sin*-function as a value for $\omega t$.
Additionally, an output signal g of the system must be measured. As the voltage of the inverter output is to be estimated, a corresponding signal has to be measured. This can be a measurement of the voltage of the grid or according to one embodiment the voltage at a capacitor of an output filter.

It is also necessary to define initial values for the first filter coefficients and a value for the constant μ, which is in fact a value corresponding to the adaption step width. One example to set these initial values is:

$$|\hat{w}_0\rangle = |0\rangle \qquad \text{for the adaptive filter taps}$$

$$\mu = 5.0\, e^{-3} \qquad \text{for the adaptation step width.}$$

The filter coefficients w can be set to zero, which is a good start up value. However, if the Kalman filter has been run before with the same or an equivalent system, the filter coefficients might have been settled at some values, which led to a good filtering result and thus could be used as start up values. The value for the adaption step with μ can be calculated by the following formula:

$$\mu = \frac{\beta}{\alpha + n \cdot \beta}$$

β corresponds to the variation or expected variation of the output value. This usually corresponds to the amount of noise and can be set to 1 V. The sensitivity factor a can be selected in a range between 100 V to 1000 V. n is the number of oscillators e.g. 10.

The Kalman filter used with reference to one embodiment of the current invention has been explained above. This identification approach can provide a numerical stability and is of a minor numerical complexity due to the simplifications. The adaptive filter can be realized on a digital signal processor (DSP) and runs at 20 kS (kilo samples) data rate, which is important for many inverter types.

One application example is given with respect to figure 4. Figure 4 shows a general structure of an output filter being connected to an inverter 2 and the grid 4. The output filter 1 is given in a T-structure. 1. e. according to the given illustration two inductances $L_0$ and $L_1$ form together with the capacitor C basically a shape of a "T". The inverter 2 is only given as a single symbol illustrating, that this inverter 2 provides a rectangular signal e. g. a pulse with modulated signal. Accordingly, the voltage switches between a positive and a negative voltage. At the output, the output filter 1 is connected to the grid 4. For the grid 4, there is just given a symbol illustrating that the voltage in the grid is basically a sinusoidal voltage signal.

It is to be noted, that figure 4 just shows the general structure of said T-shaped output filter. However, this just shows the general structure comprising the general components, i. e. the inductances $L_0$, $L_1$ and the capacitor C. There might be other components, or one or a plurality of the shown components might be split into two or more components each. According to a further embodiment, the inductance $L_1$ can also be just a wire or other connection line providing an inductive characteristic. Additionally, other filter structures might be used.

Commercial on-grid inverters based on PWM current modulation provide a lowpass filter at the inverter output to minimize current distortion. It is induced by power electronics switching or grid noise and cannot be avoided. The L-C-L filter is a well known solution. Offering acceptable roll-off (> 80 dB / decade) and good attenuation in the stop band (> 120 dB) it can be made with a minimal inductance expense, when compared to a grid connection featuring only one longitudinal inductance.

In the following it will be demonstrated how to use the method of adaptive grid synthesis to damp the filter resonances by means of active degeneration. The added value of the method lies in its high performance potential plus its minimal sensor effort. The entire signals that have to be acquired for DSP data processing according to *fig.* 4 are the filter input current $i_{L0}$ and the capacitor voltage $u_C$. The following paragraph reviews the mathematical background. It will be started with a discussion of the differential equation for the output current $i_c$ as described by Kirchhoffs law.

The parameters of the following equations correspond to the currents and voltages given in figure 4:

$$u_C = L_1 \cdot \frac{di_{L1}}{dt} + u_{net} \qquad\qquad [9]$$

$$i_C = i_{L0} - i_{L1} \qquad\qquad\qquad [10]$$

Thus

$$i_C = C \cdot \frac{du_C}{dt} \qquad\qquad\qquad [11]$$

from [9]

$$\frac{du_C}{dt} = L_1 \cdot \frac{d^2 i_{L1}}{dt^2} + \frac{du_{net}}{dt} \qquad\qquad\qquad [12]$$

insert into [11]

$$i_C = L_1 C \cdot \frac{d^2 i_{L1}}{dt^2} + C \cdot \frac{du_{net}}{dt} \qquad\qquad\qquad [13]$$

and finally resubstituting $i_c$

$$i_{L0} - i_{L1} = L_1 C \cdot \frac{d^2 i_{L1}}{dt^2} + C \cdot \frac{du_{net}}{dt} \qquad\qquad\qquad [14]$$

solving to $i_{L1}$ derivatives

$$L_1 C \cdot \frac{d^2 i_{L1}}{dt^2} + i_{L1} = i_{L0} - C \cdot \frac{du_{net}}{dt} \qquad\qquad\qquad [15]$$

simplified

$$\frac{d^2 i_{L1}}{dt^2} + \frac{1}{L_1 C} \cdot i_{L1} = i_{L0} - \frac{1}{L_1} \cdot \frac{du_{net}}{dt} \qquad\qquad\qquad [16]$$

Accordingly, equation 16 represents the differential equation of an undamped harmonic oscillator with external excitations $i_{L0}$ and $d_{Unet} / dt$.

$$\omega_0 = \sqrt{L_1 C} \qquad\qquad\qquad [17]$$

The filters Eigen-oscillation may be damped, if an active degeneration is applied by providing an additional component of the electrical current through the inductance $L_0$. Just for illustrational reasons it is assumed that this is the only component through the inductance $L_0$:

$$i_{L0} = -\gamma \cdot \frac{di_{L1}}{dt} \qquad\qquad [18]$$

In this case, the differential equation [16] will turn to

$$\frac{d^2 i_{L1}}{dt^2} + \gamma \cdot \frac{di_{L1}}{dt} + \omega_0^2 \cdot i_{L1} = -\frac{1}{L_1} \cdot \frac{du_{net}}{dt} \qquad\qquad [19]$$

This verified equation describes a damped harmonic oscillator with the attenuation parameter $\gamma$.

In other words, the basic idea of controlling the L-C-L filter is to add a negative feedback term to the input current reference that is proportional to the derivative of the output current.

Computing derivatives of digital data streams is known to be a severe problem. Due to the inevitable presence of noise in real life systems it is not possible to gather that term straight forward. Equation 9 paves the way for a smart solution. The required feedback will be measured online:

$$\frac{di_{L1}}{dt} = \frac{1}{L_1} \cdot \left( u_C - u_{net} \right) \qquad\qquad [20]$$

The aim is, to damp the T filter output current at the resonance peak. Thus lower harmonics in the feedback part can be omitted. The right hand side of equation [20] the mains $u_{net}$ does not have a rising at the Eigen-frequency $\omega_0$. The resonance obviously is an exclusive signature of the capacitor voltage $u_c$.

The complex amplitude of $di_{L1}/dt$ and $u_c$ at resonance frequency $\omega_0$ are proportional. Thus $u_c$ rid of its lower harmonics is a very good high pass approximation of $di_{L1}/dt$ which qualifies it to support active degeneration.

To illustrate: considering the principle of orthogonality the complex amplitude is given by the projection, whereby the projection is only discussed for imaginary part $sin(\omega_0 t)$, the same holds for real part $cos(\omega_0 t)$.

$$\frac{1}{2\pi} \cdot \int \frac{di_{L1}}{dt} \cdot \sin(\omega_0 t) \cdot dt =$$

$$\frac{1}{2\pi L_1} \cdot \int u_C \cdot \sin(\omega_0 t) \cdot dt - \underbrace{\frac{1}{2\pi L_1} \cdot \int u_{net} \cdot \sin(\omega_0 t) \cdot dt}_{\blacktriangleright \text{ orthogonality}} \qquad\qquad [21]$$

Imagine the capacitor voltage as a functional series

$$u_C = \underbrace{A(\omega) \cdot \cos(\omega_0 t) + B(\omega_0) \cdot \sin(\omega_0 t)}_{\text{Eigen-resonance}} + \underbrace{\sum_n A_n \cdot \cos(n\omega t) + B_n \cdot \sin(n\omega t)}_{\text{grid harmonics}} \qquad\qquad [22]$$

The projection destroys the grid harmonics.

13

$$\frac{1}{2\pi L_1} \cdot \int u_C \cdot \sin(\omega_0 t) \cdot dt =$$

$$\frac{1}{2\pi L_1} \cdot \int \left[ A(\omega_0) \cdot \cos(\omega_0 t) + B(\omega_0) \cdot \sin(\omega_0 t) \right] \cdot \sin(\omega_0 t) \cdot dt$$

$$\underline{\hspace{3cm} \text{Eigen-resonance} \hspace{3cm}}$$

$$+ \frac{1}{2\pi L_1} \cdot \int \left[ \sum_n A_n \cdot \cos(n\omega t) + B_n \cdot \sin(n\omega t) \right] \cdot \sin(\omega_0 t) \cdot dt \quad = \quad \frac{B}{L_1}$$

$$\underline{\hspace{3cm} \text{grid harmonics} \hspace{3cm}}$$

$$\underline{\hspace{5cm}}$$

► orthogonality                                        = 0                    [23]

To summarize

nanze

$$\overset{\text{Imaginary part of } di_{L_1}/dt \text{ at } \omega_0}{\overline{\hspace{3cm}}}$$

$$\frac{1}{2\pi} \cdot \int \frac{di_{L_1}}{dt} \cdot \sin(\omega_0 t) \cdot dt \quad = \quad \frac{1}{L_1} \cdot B \qquad\qquad [24]$$

Separating low from high order harmonics and rearranging [21] yields

$$\overset{\text{high order harmonics}}{\overline{\hspace{4cm}}}$$

$$u_C = A(\omega_0) \cdot \cos(\omega_0 t) + B(\omega_0) \cdot \sin(\omega_0 t) + \sum_{n \geq N} A_n \cdot \cos(n\omega t) + B_n \cdot \sin(n\omega t)$$

$$+ \sum_{n < N} A_n \cdot \cos(n\omega t) + B_n \cdot \sin(n\omega t)$$

$$\underline{\hspace{3cm} \text{low order harmonics} \hspace{3cm}} \qquad [25]$$

as

$$A(\omega_0) \cdot \cos(\omega_0 t) + B(\omega_0) \cdot \sin(\omega_0 t) \quad \gg \quad \sum_{n \geq N} A_n \cdot \cos(n\omega t) + B_n \cdot \sin(n\omega t)$$

we get the approximation

$$A(\omega_0) \cdot \cos(\omega_0 t) + B(\omega_0) \cdot \sin(\omega_0 t) \quad \approx \quad u_C - \sum_{n<N} A_n \cdot \cos(n\omega t) + B_n \cdot \sin(n\omega t) \qquad [26]$$

$\underbrace{\phantom{A(\omega_0) \cdot \cos(\omega_0 t) + B(\omega_0) \cdot \sin(\omega_0 t)}}_{\text{complex amplitude of } di_{L1}/dt \text{ at } \omega_0}$ $\underbrace{\phantom{\sum_{n<N} A_n \cdot \cos(n\omega t) + B_n \cdot \sin(n\omega t)}}_{\text{low order harmonics}}$

As a result, the complex amplitude of $di_{L1}/dt$ at $\omega_0$ can be determined by measuring the voltage at the capacitor and subtracting a signal comprising the lower order harmonics of the grid voltage. This signal, comprising the lower order harmonics of the grid is received by means of the Kalman filter as described above. Accordingly, the complex amplitude of $di_{L1}/dt$ at $\omega_0$ can be achieved without computing a derivation of the current $I_{L1}$. And thus a negative feedback term is determined and can be added to the input current reference, whereby the negative feedback term is proportional to the derivative of the output current, whereas it is not necessary to differentiate that current.

To summarize, the task to identify and remove low order grid harmonics from the capacitor voltage $u_c$ up to order $n$ is done applying the new method of Adaptive Grid Synthesis. The identification error represents a high pass approximation of $di_{L1}/dt$ covering the resonance frequency $\omega_0$. It acts as a feedback term in an active degeneration DSP algorithm.

Many proposals to control the currents in an L-C-L filter are to be found in scientific literature. Notable device tolerances and time varying grid impedance cause uncertainty to $\omega_0$ which makes it impossible to find an overall well performing damping method using one of the model based approaches. Adaptive grid synthesis can handle that remarkably well, which becomes evident through the above explanations. Moreover all low order harmonics are identified in the complex plane, therefore blind currents in the filter capacitor may be compensated on that information.

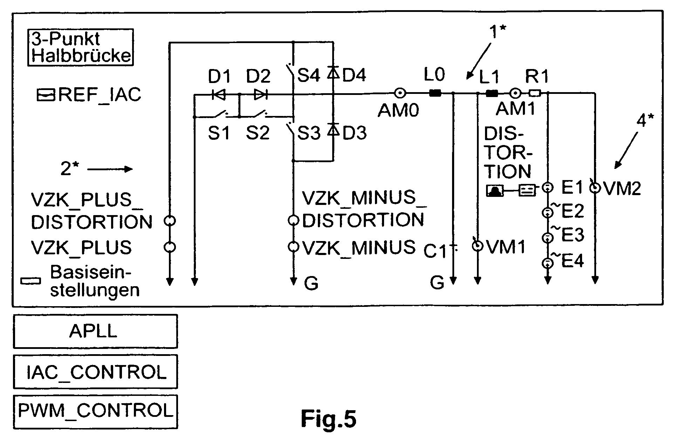

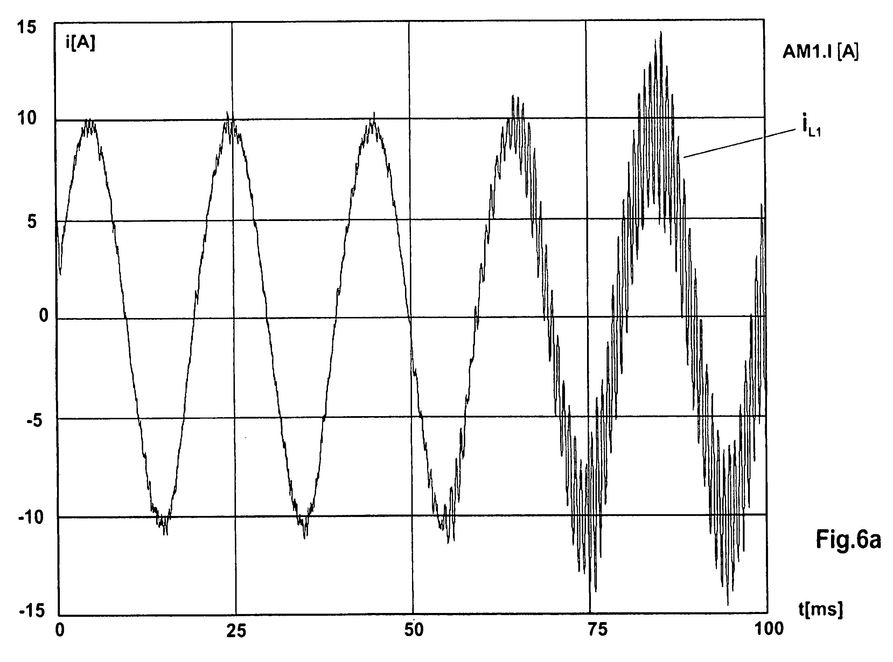

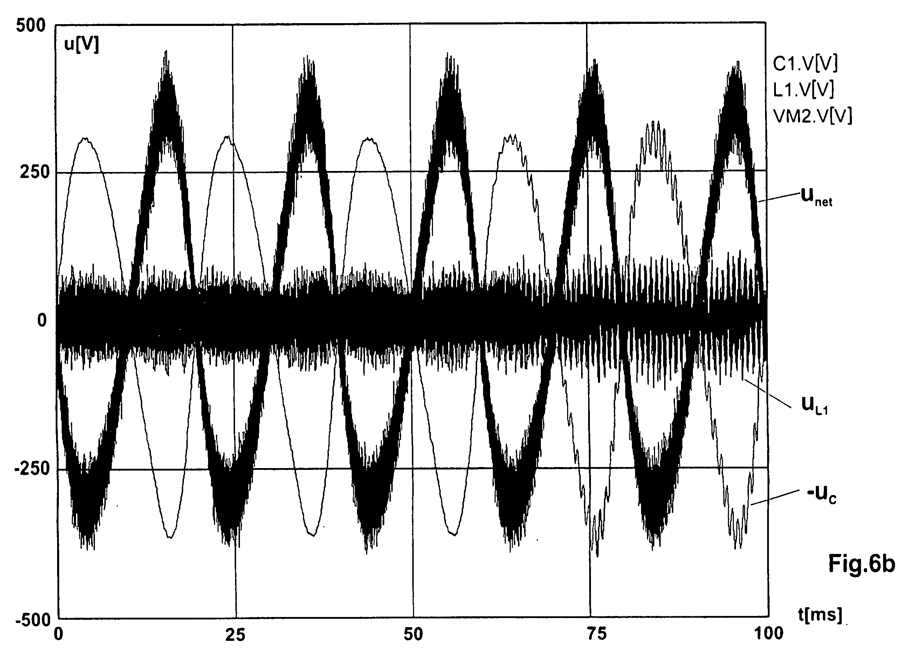

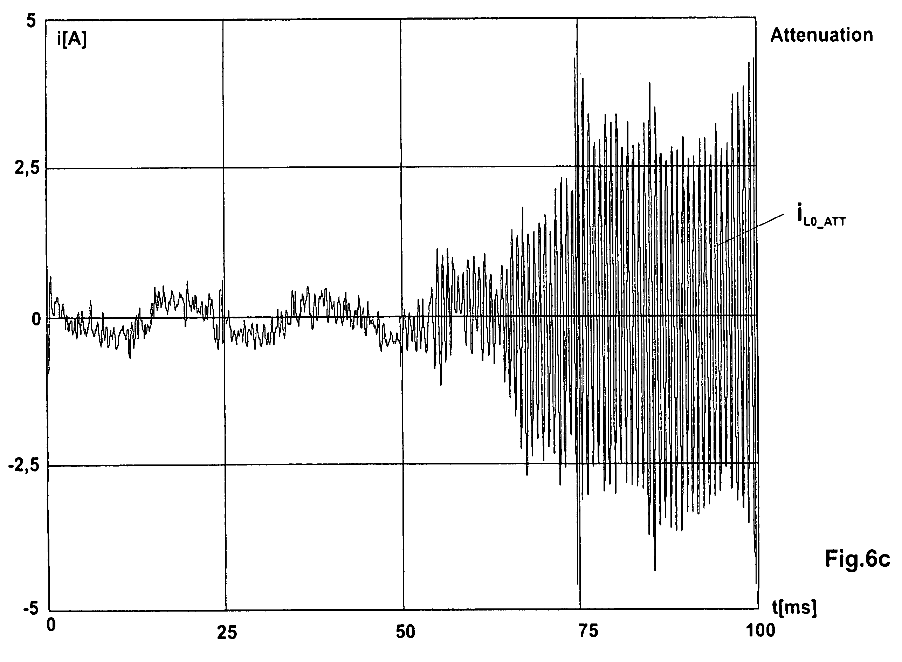

Active degeneration of the L-C-L filter shown in fig. 4 is tested in a PC simulation. The computer model is created in SIMPLORER. It is depicted in fig. 5. The adaptive grid synthesis is realized in the block APLL. The outputs of the APLL are the complex amplitudes of the identified low order grid harmonics and the identification error that is used as a feedback to damp the filter. Since the feedback acts on the input current reference, the performance of the AC-current controller is the key to successful degeneration or has at least influence on the degeneration. The controller type that is embedded in the blocks IAC_CONTROL and PWM_CONTROL features a model predictive control which, is able to generate a zero phase-lag feedback current. The input current modulation is based on a 3-level IGBT half bridge. It is to be noted, that with respect to the active degeneration it does not count whether the half bridge is pulsating in 2-level or 3-level mode. The result of the simulation is given in figure 6.

It is to be noted that, just for illustrating purposes, figure 4 shows only one output filter and thus according to that figure only one phase of electrical current can be fed into the grid. However, the same principle, using three output filters can be used for a 3-phase system.

The SIMPLORER model of figure 5 comprises of a 3-point-half bridge comprising four switches S1 to S4 and four diodes D1 to D4. The input to this three point half bridge is a positive voltage for VZK_PLUS and a negative voltage VZK-MIN. Additionally, some distortions VZK-PLUS-DIST and VZK-MIN-DIST are added to the DC-supply voltage, to get more realistic conditions. The general structure of the 3-pulse half bridge is also explained in the international application with the publication number WO 2007/048420 which is incorporated in this application by reference.

The 3-point half bridge provides an output current which is measured at AM0 and input into the output filter 1* at the inductance L0. The output current of the output filter 1* flows through the inductance L1 and is measured at the filter output at AM1. Finally, the capacitor C1 is the capacitor of the output filter 1*. The voltage of this capacitor C1 is measured at VM1. At the output of the output filter 1* there is a resistor R1 to get realistic conditions. The grid 4* is basically represented by 4 voltage sources E1 to E4. For simulating a distortion the two elements designated DISTORTION can provide a distortion signal to be added at E1. The grid voltage is measured at VM2. Many of the branches are grounded to ground G. However, this is in particular for the simulated model given. Not all realistic systems do necessarily need these groundings. Additionally, a set-value for the sinusoidal output current is represented by REF_IAC and thus provided as an input value for the inverter control.

To summarize, figure 5 shows a SIMPLORER model of an on-grid inverter output. An active degeneration is based on an adaptive grid synthesis and is implemented in the sub sheet APLL. The feedback is controlled by a 3-level IGBT switching typology. The controller is modelled in the sub sheet IAC_CONTROL and the PWM engine is emulated in the sub sheet PWM_CONTROL.

Figures 6a-c show simulation results of a 50 Hz voltage signal of the grid and the simulation covers a period of 100 ms. From 0...50 ms active degeneration is switched on and it is switched off for the period from 50 ms...100 ms. In the upper right corner of figures 6a and 6b, the source of each measurement according to the SIMPLORER model in figure 5 is indicated by designating the corresponding component and the measured value (current or voltage) subdivided by a dot and the corresponding unit. E.g.: "AM1.I[A]" stands for a measurement at the ampere meter AM1 (located in series to the inductance $L_1$), the measured value is the current ("I") and it is measured in amperes ([A]).

Figure 6a shows the current $i_{L1}$ through the inductance $L_1$. The grid voltage $u_{net}$ and the voltage at the capacitor C1, depicted with $u_c$, and the voltage $u_{L1}$ at the inductance L1 are shown in figure 6b. Finally the attenuation current signal, which is to be added to the filter input current of the inductance $L_0$ is shown in figure 6c. This current is calculated within the simulation block "APLL". The capacitor voltage $u_c$ is almost equal to the grid voltage $u_{net}$. For better illustration the sign of $u_c$ is inverted in figure 6b. Additionally, the grid voltage $u_{net}$ comprises noise. The voltage $u_{L1}$ has a much smaller amplitude than the grid voltage $u_{net}$ and the capacitor voltage $u_c$. The voltage signal $u_{L1}$. shown in Figure 6b, shows clearly much higher distortions in the second half of the figure, when the attenuation is switched off and only smaller distortions in the first half of the simulation, when the attenuation is switched on. The voltage signal $u_{L1}$ also shows a transient of the Eigen-resonance at the beginning just after 0 ms. This shows that the transient of the Eigen-resonance fades within 2 ms.

Additionally, the attenuation current signal to be applied on the output filter at the inductance L0 is illustrated in figure 6c. During the first 50 ms this attenuation current signal is applied on the output filter, whereas during the following 50 ms (50-100 ms) this attenuation current signal is only calculated, but not applied and thus the attenuation is actually switched off. During attenuation the attenuation current signal shows only small amplitudes and thus, only few current is needed, to perform the attenuation. After switching the attenuation off, the distortions rise and result in an increased demand on attenuation. Therefore, the significantly higher amplitude of the calculated, but not applied attenuation current indicates the high distortions.

Accordingly, the attenuation according to one embodiment of the invention showed successful results according to the shown simulations.

However, it is to be noted, that this simulation is only intended to demonstrate the success of the invention. The simulation is in no way meant to limit the scope of the invention. In particular, any distortion or noise and the attenuation of it might be larger or smaller in other simulations. It is also to be noted, that results of measurements may vary with respect to results of similar simulations. Any such variations in simulation or measurement results may not give any indication of the used method or device leaving the scope of the invention.

**Claims**

1. Method for detecting filter related distortions of a filter output current or voltage of an output filter of an inverter or other power source connected to the grid, comprising the steps:

   defining a general signal structure to represent an estimated signal of the filter output current or voltage by means of a sinusoidal function having a fundamental wave and at least one harmonics of higher order, whereby the sinusoidal function is defined by the frequency, amplitude and phase of the fundamental wave and the amplitude and phase of each harmonic,
   estimating the amplitude and phase of the fundamental wave and/or each harmonic by means of a filter, an adaptive filter and/or an observer, in particular a Kalman filter,
   estimating the distortions by comparing the estimated signal with a measured reference signal of the filter,
   whereby the filter related distortions are detected at a L-C-L low pass filter having two inductances and a capacitor connected in a T-structure being used as the output filter and the distortion of the output current or voltage is detected by estimating a filter output signal at the output filter and comparing it with a measured signal of the filter representing the output signal,
   whereby the voltage at the capacitor is used as the observer reference to calculate the observer error.

2. Method for minimizing the total harmonic distortion of an output current or voltage of an output filter of an inverter connected to the grid, comprising the steps:

   generating an output current by means of an inverter or other controlled power source inputted into the output filter,
   defining a general signal structure to represent an estimated signal of the filter output current or voltage by means of a sinusoidal function having a fundamental wave and at least one harmonics of higher order, whereby the sinusoidal function is defined by the frequency, amplitude and phase of the fundamental wave and the amplitude and phase of each harmonic,
   detecting a distortion signal of the filter output current or voltage based on said estimated signal by means of a filter, an adaptive filter and/or an observer, in particular a Kalman filter,
   adapting the generating of the output current to compensate for the detected distortion, whereby an L-C-L low pass filter having a T-structure with at least 2 inductances and one capacitor is used as the output filter, the distortion signal is detected by measuring the voltage at the capacitor and
the set value for the current generated by the inverter is adapted according to the measured voltage at the capacitor.

**3.** Method according to claim 2 whereby a set value for the current signal generated by the inverter is calculated by integrating or differentiating the difference of the filter output current and the filter input current.

**4.** Method according to claim 2 or 3, whereby the distortion signal is detected according to the method according to claim 1.

**5.** Method according to any of claims 2 to 4, further comprising the step of amending the inverter output current to compensate for reactive power.

**6.** Inverter or other controlled power source for feeding current into the grid, comprising:

an L.C.L low pass output filter for filtering the current,
a processing unit realized as a digital signal processor and comprising program code adapted to perform a method according to any of the aforementioned claim when executed by the digital signal processor, wherein filter related distortions are detected at the L-C-L low pass output filter.

**7.** Inverter or other controlled power source according to claim 6, whereby the low pass filter has a resonance frequency above at least the double frequency of the grid, in particular above ten times the grid frequency and in particular in the range of 1-2 kHz.

**8.** Solar system comprising a solar generator and an inverter according to any of claims 6 and 7.

**Patentansprüche**

**1.** Verfahren zum Erfassen filterbedingter Verzerrungen eines Filterausgangsstroms oder einer Spannung eines Ausgangsfilters eines Wechselrichters oder anderen Leistungsquelle, der bzw. die an das Stromnetz angeschlossen ist, umfassend die Schritte:

Definieren einer allgemeinen Signalstruktur zur Darstellung eines geschätzten signals des Filterausgangsstroms oder der Spannung mit Hilfe einer sinusförmigen Funktion mit einer Grundwelle und mindestens einer Harmonischen höherer Ordnung, wobei die sinusförmige Funktion durch die Frequenz, Amplitude und Phase der Grundwelle und die Amplitude und Phase jeder Harmonischen definiert ist,
Schätzen der Amplitude und Phase der Grundwelle und/oder jeder Harmonischen mit Hilfe eines Filters, eines adaptiven Filters und/oder eines Beobachters, insbesondere eines Kalman-Filters,
Schätzen der Verzerrungen durch einen vergleich des geschätzten Signals mit einem gemessenen Referenzsignal des Filters,
wobei die filterbedingten Verzerrungen an einem L-C-L-Tiefpassfilter mit zwei Induktivitäten und einem Kondensator erfasst werden, die in einer T-Struktur verbunden sind, der als Ausgangsfilter verwendet wird, und die Verzerrung des Ausgangsstroms oder der Spannung durch Schätzen eines Filterausgangssignals am Ausgangsfilter und Vergleichen desselben mit einem gemessenen Signal des Filters, das das Ausgangssignal darstellt, erfasst werden,
wobei die Spannung am Kondensator als die Beobachterreferenz zur Berechnung des Beobachterfehlers verwendet wird.

**2.** Verfahren zur Minimierung der gesamten harmonischen Verzerrung eines Ausgangsstroms oder einer Spannung eines Ausgangsfilters eines wechselrichters, der an das Stromnetz angeschlossen ist, umfassend die schritte:

Erzeugen eines Ausgangsstroms mit Hilfe eines Wechselrichters oder einer anderen gesteuerten Leistungsquelle, der in das Ausgangsfilter eingegeben wird,
Definieren einer allgemeinen Signalstruktur zur Darstellung eines geschätzten Signals des Filterausgangsstroms oder der Spannung mit Hilfe einer sinusförmigen Funktion mit einer Grundwelle und mindestens einer Harmonischen höherer Ordnung, wobei die sinusförmige Funktion durch die Frequenz, Amplitude und Phase der Grundwelle und die Amplitude und Phase jeder Harmonischen definiert ist,

Erfassen eines verzerrungssignals des Filterausgangsstroms oder der Spannung auf der Basis des geschätzten Signals mit Hilfe eines Filters, adaptiven Filters und/oder eines Beobachters, insbesondere eines Kalman-Filters, Anpassen der Erzeugung des Ausgangsstroms zum Ausgleichen der erfassten Verzerrung, wobei ein L-C-L-Tiefpassfilter mit einer T-Struktur mit mindestens zwei Induktivitäten und einem Kondensator als Ausgangsfilter verwendet wird, wobei das Verzerrungssignal durch Messen der Spannung am Kondensator erfasst wird, und der Sollwert für den Strom, der vom Wechselrichter erzeugt wird, in Übereinstimmung mit der gemessenen Spannung am Kondensator angepasst wird.

3. Verfahren nach Anspruch 2, wobei ein Sollwert für das Stromsignal, das vom Wechselrichter erzeugt wird, durch Integrieren oder Differenzieren der Differenz des Filterausgangsstroms und des Filtereingangsstroms berechnet wird.

4. Verfahren nach Anspruch 2 oder 3, wobei das Verzerrungssignal gemäß dem Verfahren nach Anspruch 1 erfasst wird.

5. Verfahren nach einem der Ansprüche 2 bis 4, des Weiteren umfassend den Schritt Ändern des Ausgangsstroms des Wechselrichters zum Kompensieren einer Blindleistung.

6. Wechselrichter oder andere gesteuerte Leistungsquelle zum Einspeisen von Strom in das Stromnetz, umfassend:

   ein L-C-L-Tiefpassausgangsfilter zum Filtern des Stroms,
   eine Verarbeitungseinheit, die als digitaler Signalprozessor ausgeführt ist und einen Programmcode umfasst, der zur Ausführung eines Verfahrens nach einem der vorangehenden Ansprüche ausgebildet ist, wenn er von dem digitalen Signalprozessor ausgeführt wird, wobei filterbedingte Verzerrungen am L-C-L-Tiefpassausgangsfilter erfasst werden.

7. Wechselrichter oder andere gesteuerte Leistungsquelle nach Anspruch 6, wobei das Tiefpassfilter eine Resonanzfrequenz oberhalb mindestens der doppelten Frequenz des Stromnetzes hat, insbesondere oberhalb dem Zehnfachen der Stromnetzfrequenz und insbesondere im Bereich von 1-2 kHz.

8. Solarsystem, umfassend einen Solargenerator und einen Wechselrichter nach einem der Ansprüche 6 und 7.

**Revendications**

1. Procédé de détection de distorsions liées au filtre d'un courant ou d'une tension de sortie d'un filtre de sortie d'un onduleur ou d'une autre source de puissance connectée au réseau électrique, comprenant les étapes suivantes :

   la définition d'une structure de signal générale pour représenter un signal estimé du courant ou de la tension de sortie de filtre au moyen d'une fonction sinusoïdale ayant une onde fondamentale et au moins une harmonique de rang supérieur, moyennant quoi la fonction sinusoïdale est définie par la fréquence, l'amplitude et la phase de l'onde fondamentale et l'amplitude et la phase de chaque harmonique,
   l'estimation de l'amplitude et de la phase de l'onde fondamentale et/ou de chaque harmonique au moyen d'un filtre, d'un filtre adaptatif et/ou d'un observateur, en particulier d'un filtre de Kalman,
   l'estimation des distorsions en comparant le signal estimé à un signal de référence mesuré du filtre,
   moyennant quoi les distorsions liées au filtre sont détectées au niveau d'un filtre passe-bas LCL ayant deux inductances et un condensateur connectés en une structure en T utilisé comme filtre de sortie et la distorsion du courant ou de la tension de sortie est détectée en estimant un signal de sortie de filtre au niveau du filtre de sortie et en le comparant à un signal mesuré du filtre représentant le signal de sortie,
   moyennant quoi la tension au niveau du condensateur est utilisée comme référence d'observateur pour calculer l'erreur d'observateur.

2. Procédé de minimisation de la distorsion harmonique totale d'un courant ou d'une tension de sortie d'un filtre de sortie d'un onduleur connecté au réseau électrique, comprenant les étapes suivantes :

   la génération d'un courant de sortie au moyen d'un onduleur ou d'une autre source de puissance commandée émise en entrée dans le filtre de sortie,
   la définition d'une structure de signal générale pour représenter un signal estimé du courant ou de la tension de sortie de filtre au moyen d'une fonction sinusoïdale ayant une onde fondamentale et au moins une harmonique de rang supérieur, moyennant quoi la fonction sinusoïdale est définie par la fréquence, l'amplitude et la phase de l'onde fondamentale et l'amplitude et la phase de chaque harmonique,

la détection d'un signal de distorsion du courant ou de la tension de sortie de filtre à partir dudit signal estimé au moyen d'un filtre, d'un filtre adaptatif et/ou d'un observateur, en particulier d'un filtre de Kalman,

l'adaptation de la génération du courant de sortie pour compenser la distorsion détectée, moyennant quoi un filtre passe-bas LCL ayant une structure en T avec au moins 2 inductances et un condensateur est utilisé comme filtre de sortie, le signal de distorsion est détecté en mesurant la tension au niveau du condensateur et

la valeur établie pour le courant généré par l'onduleur est adaptée selon la tension mesurée au niveau du condensateur.

3. Procédé selon la revendication 2, moyennant quoi une valeur établie pour le signal de courant généré par l'onduleur est calculée en intégrant ou différenciant la différence entre le courant de sortie de filtre et le courant d'entrée de filtre.

4. Procédé selon la revendication 2 ou 3, moyennant quoi le signal de distorsion est détecté selon le procédé selon la revendication 1.

5. Procédé selon l'une quelconque des revendications 2 à 4, comprenant en outre l'étape de modification du courant de sortie d'onduleur pour compenser la puissance réactive.

6. Onduleur ou autre source de puissance commandée pour alimenter en courant le réseau électrique, comprenant :

un filtre de sortie passe-bas LCL pour filtrer le courant,

une unité de traitement réalisée en tant que processeur de signal numérique et comprenant un code de programme adapté pour effectuer un procédé selon l'une quelconque des revendications précédentes lorsqu'il est exécuté par le processeur de signal numérique, dans lequel des distorsions liées au filtre sont détectées au niveau du filtre de sortie passe-bas LCL.

7. Onduleur ou autre source de puissance commandée selon la revendication 6, moyennant quoi le filtre passe-bas a une fréquence de résonnance au-dessus au moins de la double fréquence du réseau électrique, en particulier au-dessus de dix fois la fréquence du réseau électrique et en particulier de 1 à 2 kHz.

8. Système solaire comprenant un générateur solaire et un onduleur selon l'une quelconque des revendications 6 et 7.

**Fig.1**

**Fig.2**

main voltage

public or
island grid

filter taps

NCO1...NCO10

$A_n$

$B_n$

$-$

adaptive filter

error feedback

**Fig.3**

1

$L_0$  $I_{L0}$   $I_{L1}$   $L_1$

2

$I_c$

4

$U^+/U^-$    $U_c$    $C$    $U_{net}$

**Fig.4**

**Fig.5**

AM1.I [A]

$i_{L1}$

i[A]

15

10

5

0

-5

-10

-15

0    25    50    75    100    t[ms]

Fig.6a

Fig.6b

Fig.6c

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4364378 A

- WO 2007048420 A

**Non-patent literature cited in the description**

- **BEIDES H M et al.** *DYNAMIC STATE ESTIMATION OF POWER SYSTEM HARMONICS USING KALMAN FILTER METHODOLOGY*